# EUROPEAN PATENT SPECIFICATION

(11) **EP 0 544 548 B1**
(45) Date of publication and mention of the grant of the patent: **11.11.1998**
(21) Application number: 92310909.4
(22) Date of filing: 30.11.1992
(51) Int. Cl.: F02P 17/00, G01R 15/06, G01R 31/00

(54) **A sparkplug voltage probe device in an internal combustion engine**
Spannungstester für Zündkerzen in einer Brennkraftmaschine
Testeur de potentiel de bougie d'allumage dans un moteur à combustion interne

(30) Priority: 28.11.1991 JP 314783/91; 29.11.1991 JP 316685/91; 11.05.1992 JP 117683/92; 13.11.1992 JP 303859/92
(43) Date of publication of application: 02.06.1993
(60) Divisional application: 95120721.6
(73) Proprietor: NGK SPARK PLUG CO., LTD, Nagoya-shi (JP)
(72) Inventor: Miyata, Shigeru, Mizuho-ku, Nagoya-shi (JP); Yoshida, Hideji, Mizuho-ku, Nagoya-shi (JP); Yamada, Yoshitaka, Mizuho-ku, Nagoya-shi (JP); Matsubara, Yoshihiro, Mizuho-ku, Nagoya-shi (JP); Ito, Yasuo, Mizuho-ku, Nagoya-shi (JP)
(74) Representative: Senior, Alan Murray

(56) References cited:
- EP-A- 0 032 647
- GB-A- 2 116 329
- US-A- 4 090 130
- US-A- 5 001 431

## Description

This invention relates to a probe for the detection of a voltage applied to a spark plug to detect faulty firing in an internal combustion engine.

With the demand of purifying emission gases and enhancing fuel efficiency of internal combustion engines it has been necessary to detect the firing condition in each cylinder of an internal combustion engine so as to protect internal combustion engine plugs against misfire. In order to detect the firing condition in each of the cylinders, it is known to install an optical sensor within the cylinders. Alternatively, it is also known to attach a piezoelectric sensor to a seat pad of a spark plug.

Using the prior art techniques it is troublesome and time-consuming to install a sensor in each of the cylinders. This increases installation costs and at the same time takes a lot of time both to check and in maintenance.

Document GB-A-2,116,329, upon which disclosure the preamble of claim 1 is based, describes a system for recognising misfiring in an internal combustion engine on the basis of voltage change signals in a capacitance formed between spark plug cables and an electrode.

It is one of the objects of the present invention to provide a sparkplug voltage probe device in an internal combustion engine, which is capable of detecting a voltage applied to the spark plug installed to each cylinder of the internal combustion engine precisely, using a relatively simple structure.

According to the present invention there is provided a sparkplug voltage probe device for attachment to an internal combustion engine and for detecting a voltage applied to spark plugs installed in the internal combustion engine by way of corresponding cables, said device comprising:
an insulator base having a plurality of grooves in which the corresponding cables are to be placed;
an electrode layer embedded in the insulator base along the grooves for forming a static capacitance between the electrode layer and placed cables when the voltage is applied across the spark plugs; and
a lead wire provided for connecting the electrode layer electrically to a microcomputer, so as to analyze the burning condition in the engine based on the static capacitance between the electrode layer and the cables; characterised by further comprising
an electrical shield layer embedded in the insulator base in the proximity of the electrode layer, and located at a side of the electrode layer remote from the grooves so as to shield the electrode layer electrically, the electrical shield layer being connectable to the engine for grounding.

The present invention also provides an internal combustion engine to which such a device is attached.

The electrode layer may be flat, or it may have a flat central portion and straight or curved portions at its sides which are inclined towards and around the outer grooves, or it may follow the contours of the grooves.

According to this invention, a substantially uniform static capacitance is formed between an insulator base and spark plug cables so that it is sufficient to detect a sparkplug voltage in each of the cylinders in the combustion engine with a single sparkplug voltage probe device. The use of an electrical shield sheet makes it possible to prevent a static capacitance from occurring between an electrode plate and the perimeter parts of the engine with the device is mounted on an engine, thus avoiding sensitivity variation of the sparkplug voltage probe device depending on where the probe device is mounted.

Further, since a substantially uniform static capacitance is formed between each sparkplug cable and corresponding groove of an electrode plate, a substantially constant sparkplug voltage is obtained in each cylinder of the internal combustion engine, thus making it possible to detect a burning condition in the internal combustion engine precisely.

Adhesive filler may be provided between an upper half and a lower half of an insulator base, thus preventing the entry of water into the insulator base and avoiding capacitance changes between the sparkplug cables and the electrode plate so as to prevent a faulty voltage from being detected by the probe device.

According to one embodiment of the invention bores are formed by the combination of grooves provided both on an upper portion of the insulator base and on a lower portion of the insulator base. The electrode layer is formed by plates both above and below the bores which are electrically connected along the side.

These and other objects and advantages of the invention will become apparent from the following description, meant by way of example, with reference to the accompanying drawings, in which:
Fig. 1 is a perspective exploded view of a first non-embodiment sparkplug voltage probe device;
Fig. 2 is a perspective view of the sparkplug voltage probe device of Fig. 1;
Fig. 3 is a perspective view with the sparkplug voltage probe device of Fig. 1 mounted on an internal combustion engine;
Fig. 4 is a schematic view of an ignition system incorporated into the internal combustion engine of Fig. 3;
Fig. 5 is a view similar to Fig. 1 showing a second non-embodiment sparkplug voltage probe device;
Fig. 6 is a view similar to Fig. 1 according to a first embodiment of the invention;
Fig. 7 is a view similar to Fig. 1 according to a second embodiment of the invention;
Fig. 8 is a view similar to Fig. 1 according to a third embodiment of the invention;
Fig. 9 is a view similar to Fig. 1 including an electrode plate for use in a sparkplug voltage probe device of the invention;
Fig. 10 is a longitudinal cross sectional view of a sparkplug voltage probe device having another electrode plate which can be used according to the present invention;
Fig. 11 is a similar view to Fig. 10 showing yet another electrode plate;
Fig. 12 is a perspective view of a sparkplug voltage probe device of a third non-embodiment in a closed state;
Fig. 13 is a perspective view of the sparkplug voltage probe device of Fig. 12 in an open state;
Fig. 14 is a perspective view of the sparkplug voltage probe device of Fig. 12 with sparkplug cables located in grooves;
Fig. 15 is a view of the device of Fig. 12 in a perspective view similar to Fig. 3;
Fig. 16 is a perspective view similar to Fig. 12 according to a fourth embodiment of the invention;
Fig. 17 is a perspective view similar to Fig. 12 according to a fifth embodiment of the invention;
Fig. 18 is a perspective view similar to Fig. 12 according to a sixth embodiment of the invention.

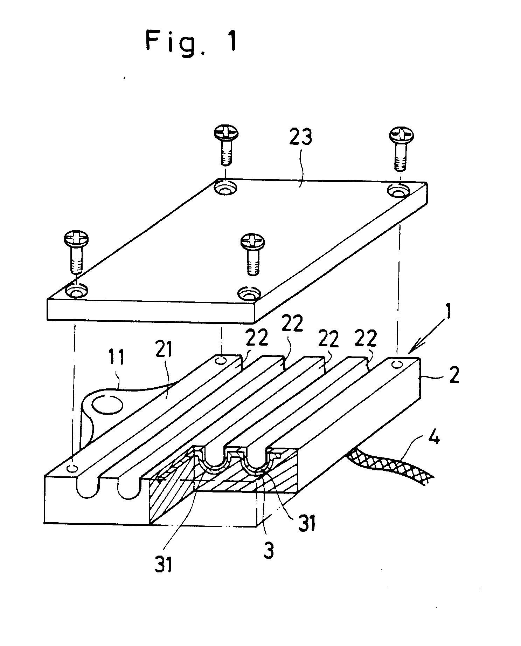

Referring to Fig. 1, this shows a sparkplug voltage probe device 1 in an internal combustion engine. This is not an embodiment of the invention but may be useful in providing understanding of the later described embodiment. An insulator base 2 has a rectangular upper surface 21 in which a plurality of grooves 22 are provided at regular intervals in a longitudinal direction. Each of the grooves 22 is U-shaped in section. Bach diameter of the grooves 22 corresponds to that of sparkplug cables (HC), and the number of the grooves 22 corresponds to that of cylinders of the internal combustion engine. Along the grooves 22, an electrode plate 3 is embedded in the insulator base 2. The electrode plate 3 is in the form of a corrugated configuration which has channels 31 corresponding to the grooves 22 of the insulator base 2. The electrode plate 3 is embedded in the insulator base 2 at the time when the insulator base 2 is formed by means of an injection mould, and electrode plate 3 is electrically connected to a microcomputer as described hereinafter. An anchor block 11 is moulded at a side wall of the insulator base 2.

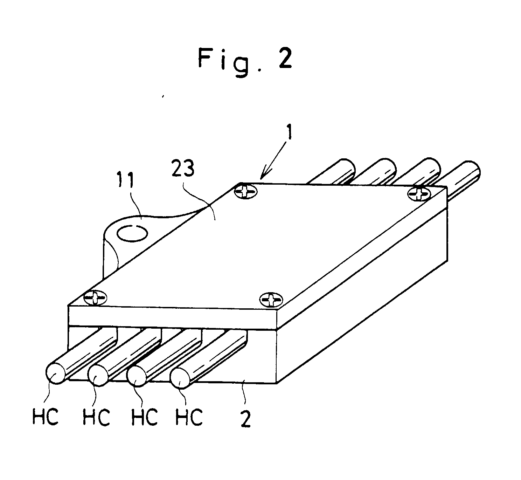

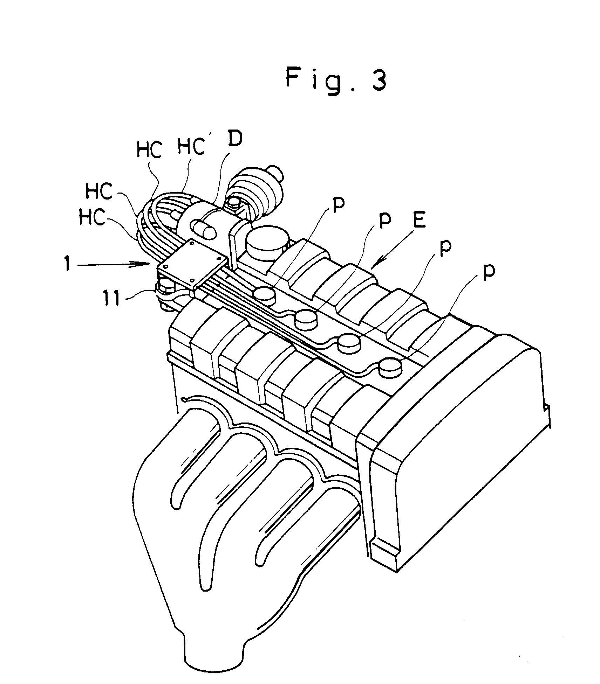

In each of the grooves 22, is a cable (HC) located to form a static capacitance (e.g. 1 pF) between the electrode plate 3 and the cables (HC) as shown in Fig. 2. On the upper surface 21 of the insulator base 2, is a lid 23 placed to secure each of the cables (HC) against removal. Then the sparkplug voltage probe device 1 is mounted on an internal combustion engine (E) by securing the anchor block 11 to a cylinder head of the internal combustion engine (E), and collects the cables (HC) to introduce them to a distributor (D) as shown in Fig. 3.

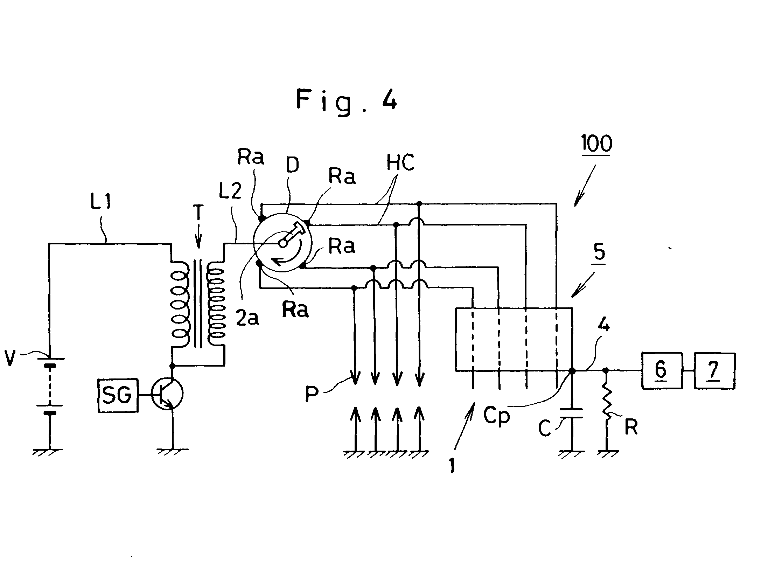

Fig. 4 shows an ignition system 100 which is incorporated into the internal combustion engine (E). The ignition system has an ignition coil (T) having a primary coil (L1) and a secondary coil (L2). In series with the primary coil (L1), are a vehicular battery cell (V) and a signal generator (SG) connected. Each of the cables (HC) has one end electrically connected to the secondary coil (L2), through a rotor 2a of the distributor (D) which integrally incorporates a contact breaker (not shown) and has e.g. four stationary segments (Ra). The cables (HC) pass through a voltage divider circuit(s) described hereafter. To each of the stationary segments (Ra), a free end of the rotor 2a approaches to make a series gap with the corresponding segments (Ra) during the rotary movement of the rotor 2a. To each of the four stationary segments (Ra), is a spark plug (P) electrically connected by way of the corresponding cables (HC). Each of the spark plugs (P) is electrically connected to ground so that the secondary coil (L2) energizes each of the spark plugs (P) by way of the cables (HC), the rotor 2a and the stationary segment (Ra) of the distributor (D).

A common point (Cp) between the electrode plate 3 and the lead wire 4, is grounded by way of a capacitor C (3000 pF) to form the voltage divider circuit 5. In parallel with the capacitor (C), is an electrical resistor R (e.g. 3 MΩ) connected to form a discharge circuit for the capacitor (C). The voltage divider circuit 5 divides a sparkplug voltage by the order of 3000. The RC time constant is 9 milliseconds, thus making it possible to observe a relatively slow change of the sparkplug voltage.

Meanwhile, the lead wire 4 is connected to a sparkplug voltage waveform detector circuit 6. The circuit 6 is connected to a distinction circuit (microcomputer) 7 which analyses a burning condition in the internal combustion engine (E) on the basis of the waveform outputted from the circuit 6 as described hereinafter.

The sparkplug voltage waveform detector circuit 6 analyses a divided voltage waveform generated from the voltage divider circuit 5, and compares the characteristics of the divided voltage waveform with data determined by experiment.

The divided voltage waveform is analogous to that of the sparkplug voltage, and changes depending upon the case in which an air-fuel mixture is normally ignited, and the case in which the air-fuel mixture is not ignited although a spark is established by the spark plug (P). The divided voltage waveform also changes depending upon the smoking of the spark plug (P), deterioration of the ignition coil (T) and a shortage of the vehicular battery cell (V).

Analysis of the divided voltage waveform makes it possible to distinguish normal ignition from accidental misfire and misspark.

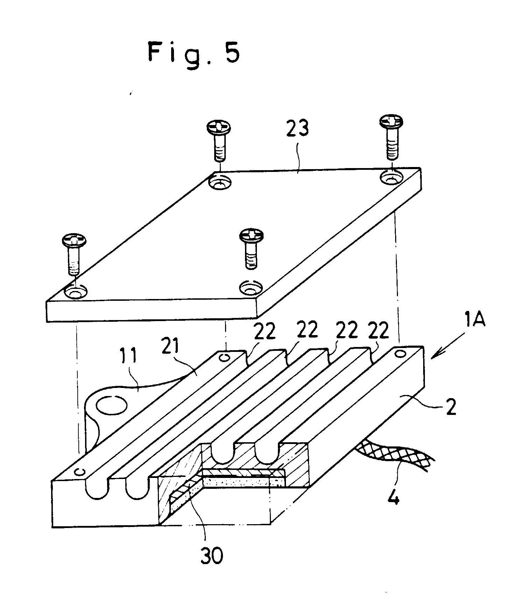

Fig. 5 shows a second device which is also not in accordance with the present invention, in which a sparkplug voltage probe device 1A has a flat electrode plate 30 instead of the corrugated configuration. Due to a simple structure of the flat electrode plate 30, the plate 30 is readily embedded in the insulator base 2.

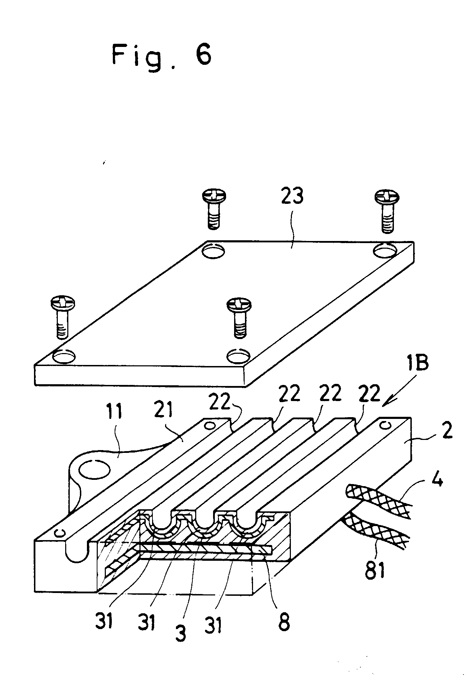

Fig. 6 shows a first embodiment of the invention in which a sparkplug voltage probe device 1B has an electrical shield sheet 8 embedded in the insulator base 2 of the first device, located under the electrode plate 3. The electrical shield sheet 8 is connected to the internal combustion engine (E) by way of a ground wire 81.

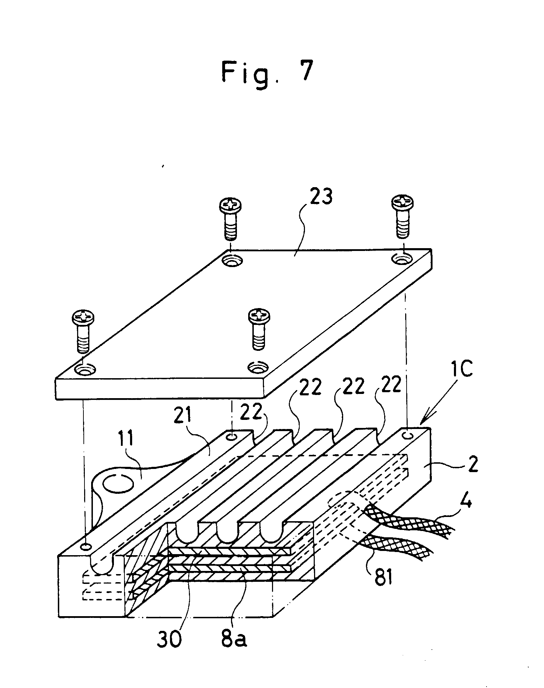

Fig. 7 shows a second embodiment of the invention in which a sparkplug voltage probe device 1C has an electrical shield sheet 8a embedded in the insulator base 2 of the second device, located under the electrode plate 30. The electrical shield sheet 8a is connected to the internal combustion engine (E) by way of the ground wire 81. It is observed that the electrical shield sheet may be in the form of meshes or a layer.

With the use of the electrical shield sheet, it is possible to prevent capacitive variation between the electrode plate and the cables when some metallic conductor is present at the perimeter of the spark plug voltage probe device. This enables precise detection of the voltage waveform from the voltage divider circuit.

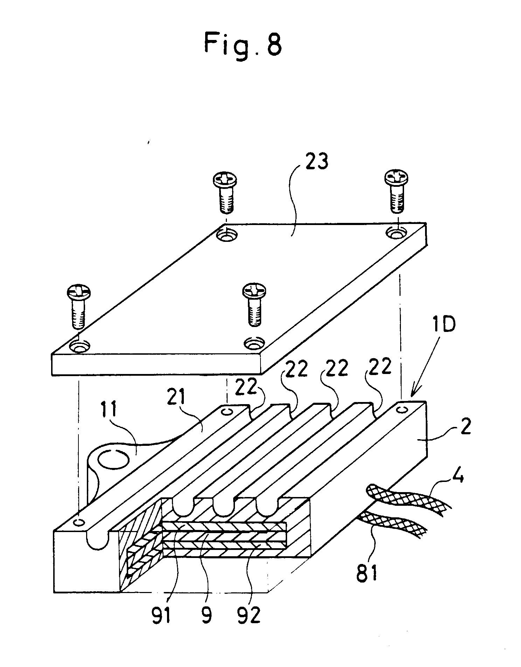

Fig. 8 shows a third embodiment of the invention in which a sparkplug voltage probe device 1D has an insulator sheet 9 embedded in the insulator base 2. An electrode layer 91 is provided on an upper surface of the insulator sheet 9, while an electrical shield layer 92 is provided on a lower surface of the insulator sheet 9. The insulator sheet 9 may be made of vitreous material, epoxy resin or polyimide resin. With the use of the insulator sheet 9, the electrode layer 91 and the shield layer 92 are readily embedded in the insulator base 2. The use of the insulator sheet 9 makes it possible to reduce the thickness of the insulator base 2 as a whole.

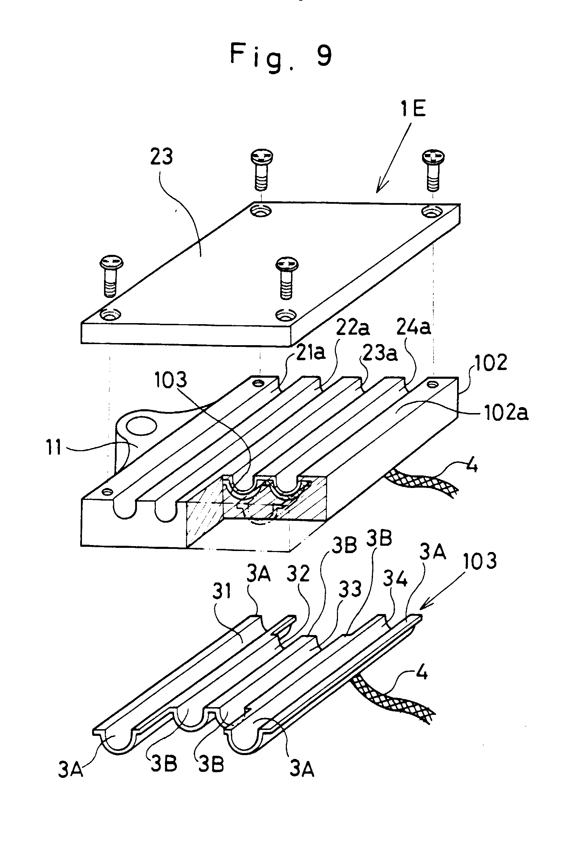

If the electrode plate is corrugated then, as shown in Fig. 9, the longitudinal ends 3A, of its outside channels 31, 34 can extend beyond longitudinal ends 3B, 3B of the inside channels 32, 33 respectively. Thereby, each length of outside channels 31, 34 is greater than that of the inside channels 32, 33 so as to form substantially an H-shaped configuration as a whole.

This enables the device to compensate effectively for capacitive shortage so that the static capacitance between the cables 41, 44 and the outside channels 31, 34 is substantially equal to the static capacitance between the cables 42, 43 and the inside channels 32, 33, thus making it possible to avoid differences among the static capacitances between each of the cables and the corresponding channels.

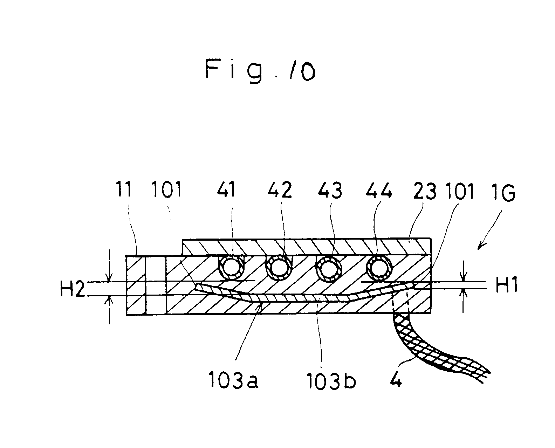

Alternatively a device according to the present invention may have a rectangular sheet 103a, both sides 101 of which turn upward to approach the cables 41, 44, as shown in Fig. 10, so that a distance (H1) between the cables 41, 44 and the sides 101 is shorter than a distance (H2) between the cables 42, 43 and a central flat portion 103b of the sheet 103a.

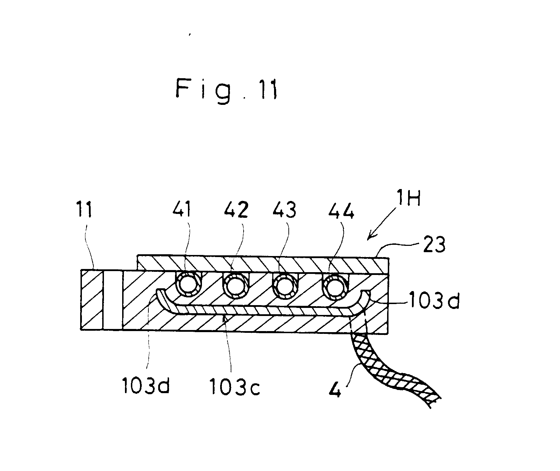

As another alternative, as shown in Fig. 11 the spark plug voltage probe device 1H may have a rectangular sheet 103c, both sides 103d of which curl around the cables 41, 44 to form an arcuate configuration.

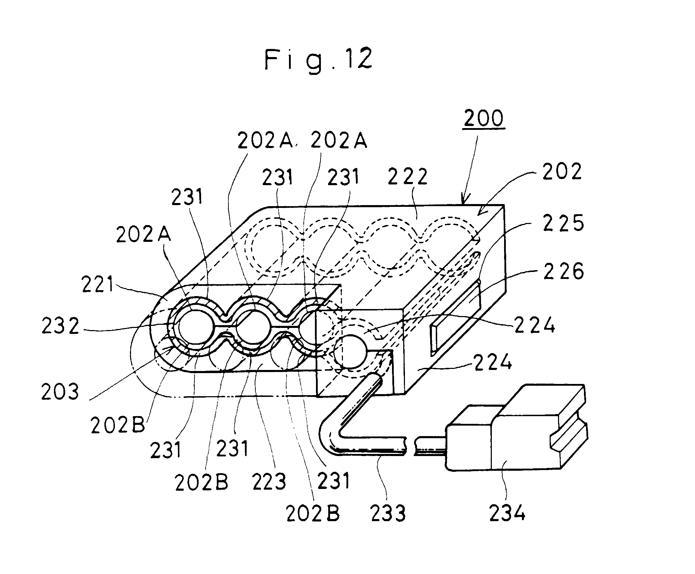

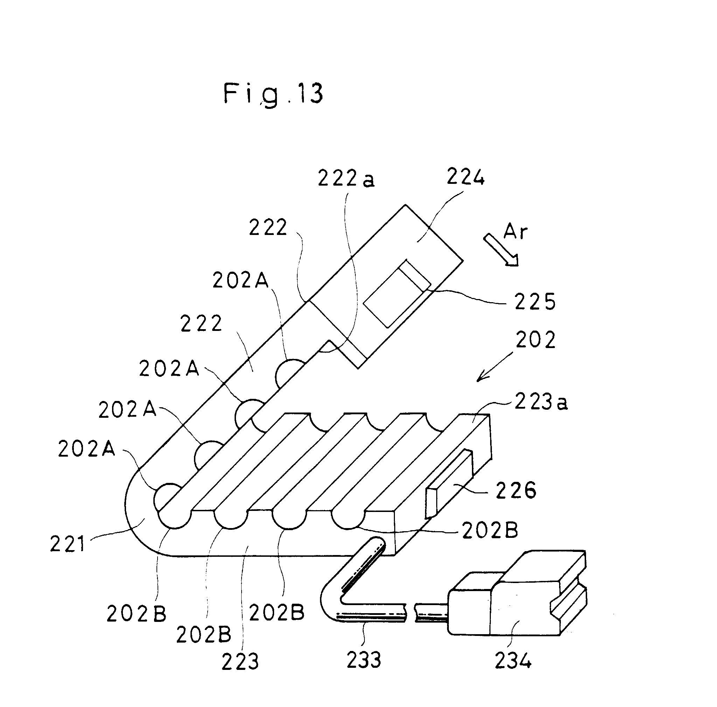

Referring to Figs. 12 and 13 which show a third non-embodiment, a sparkplug voltage probe device 200 has an insulator base 202 including an upper half 222 and a lower half 223 which are integrally connected by a flexible portion 221. On a lower surface 222a of the upper half 222, are grooves 202A provided at regular intervals. On an upper surface 223a of the lower half 223, grooves 202B are provided which correspond to the grooves 202A. In the insulator base 202, is an electrode plate 232 embedded along the grooves 202A, 202B. The electrode plate 232 is in the form of corrugated configuration which has channels 231 in correspondence to the grooves 202A, 202B. The electrode plate 232 is connected to a connector 234 by way of a lead wire 233.

From an open position in which the upper half 222 is away from the lower half 223 as shown in Fig. 13, the upper half 222 is pivotted around the flexible portion 221 in the direction of an arrow (Ar) to occupy a closed position in which the upper half 222 snugly fits on the lower half 223 as shown in Fig. 12. One end of the upper half 222 integrally carries an elastic plate 224 having an opening 225 which admits a protrusion 226 provided with one end of the lower half 223 to latch the upper half 222 in the closed position.

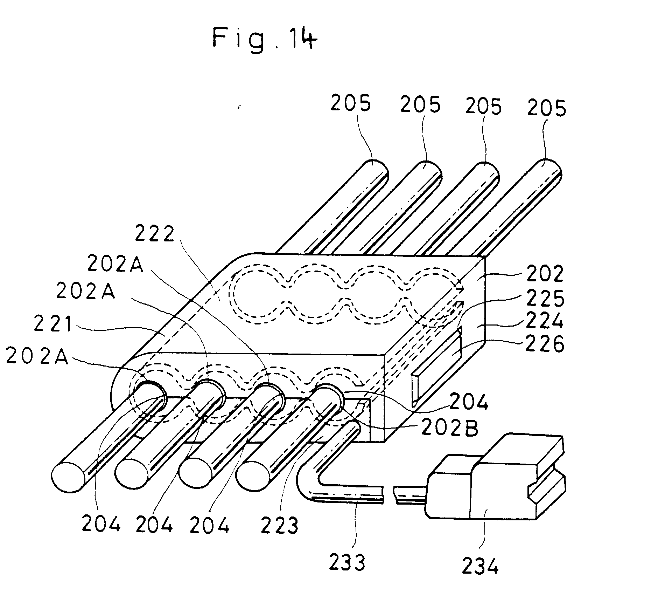

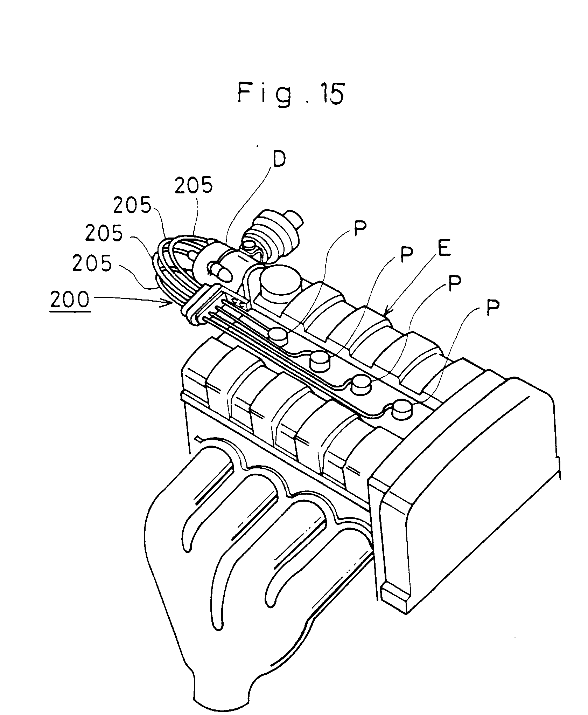

During the process of folding the upper half 222 from the open position to the closed position, sparkplug cables 205 are liquid-tightly placed in the corresponding grooves 202A, 202B by way of an adhesive filler 204 as shown in Fig. 14. Then the sparkplug voltage probe device 200 is mounted on the internal combustion engine (E) to collect the cables 205 from the spark plugs (P) so as to introduce the cables 205 to the distributor (D) as shown in Fig. 15.

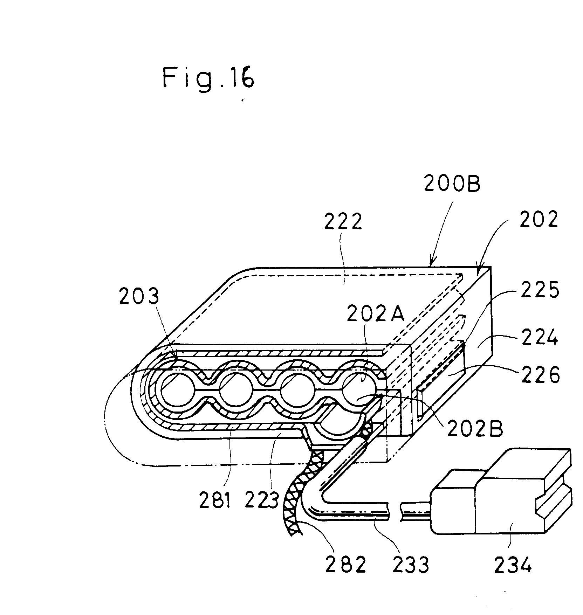

Fig. 16 shows a fourth embodiment of the invention in which a spark plug voltage probe device 200B has an electrical shield sheet 281 embedded in the insulator base 202 around corrugated electrode plate 203. The shield sheet 281 is connected to the internal combustion engine (E) by way of a ground wire 282.

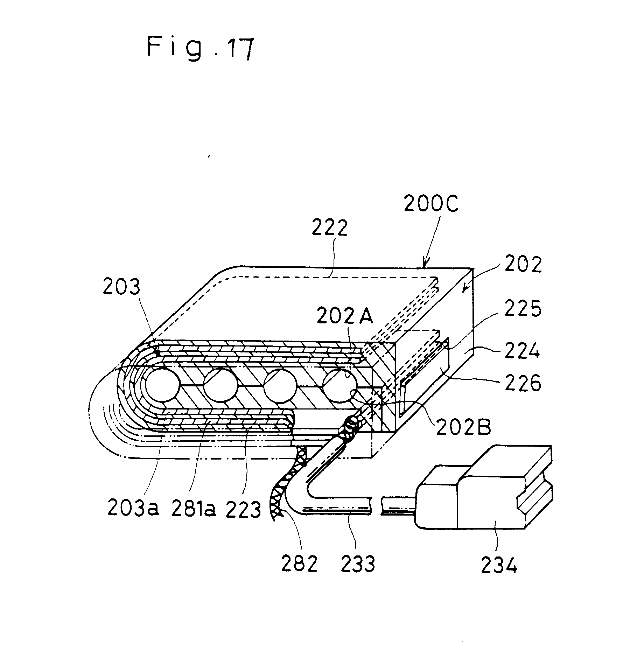

Fig. 17 shows a fifth embodiment of the invention in which a spark plug voltage probe device 200C has an electrical shield sheet 281a embedded in an insulator base 202 around a flat shaped electrode plate 203a.

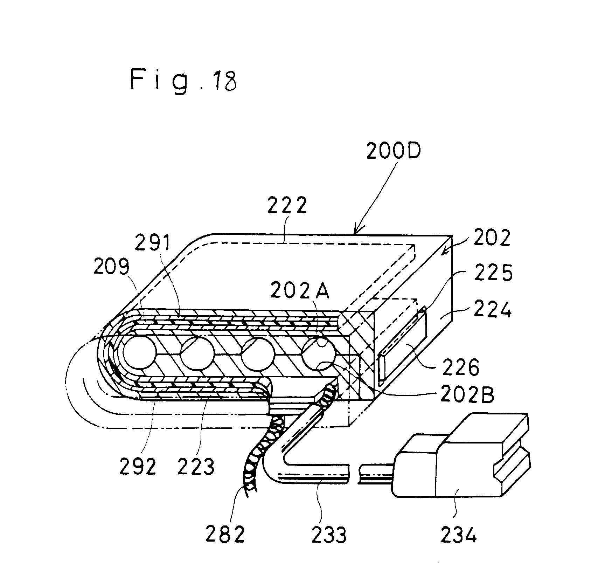

Fig. 18 shows a sixth embodiment of the invention in which a spark plug voltage probe device 200D has an insulator sheet 209 made of a polyimide resin, for example. An electrode layer 291 is provided on an inner surface of the insulator sheet 209, and an electrical shield layer 292 is provided on an outer surface of the insulator sheet 209. It is observed that the electrode layer 291 and the shield layer 292 may be of electrically conductive rubber or a metallic net of appropriate inch meshes.

## Claims

1. A sparkplug voltage probe device (lB;lC;lD; 200B;200C;200D) for attachment to an internal combustion engine (E) and for detecting a voltage applied to spark plugs (P) installed in the internal combustion engine (E) by way of corresponding cables (HC;205), said device comprising:
an insulator base (2;202) having a plurality of grooves (22;202A,202B) in which the corresponding cables (HC;205) are to be placed;
an electrode layer (3;30;91;203;203a;291) embedded in the insulator base (2;202) along the grooves (22;202A,202B) for forming a static capacitance between the electrode layer (3;30;91;203;203a;291) and placed cables (HC;205) when the voltage is applied across the spark plugs (P); and
a lead wire (4;233) provided for connecting the electrode layer (3;30;91;203;203a;291) electrically to a microcomputer (7), so as to analyze the burning condition in the engine (E) based on the static capacitance between the electrode layer (3;30;91;203;203a;291) and the cables (HC;205); characterised by further comprising
an electrical shield layer (8;8a;92;222;281a;292) embedded in the insulator base (2;202) in the proximity of the electrode layer (3;30;91;203;203a;291), and located at a side of the electrode layer (3;30;91;203;203a;291) remote from the grooves (22;202A,202B) so as to shield the electrode layer (3;30;91;203;203a;291) electrically, the electrical shield layer (8;8a;92;222;281a;292) being connectable to the engine (E) for grounding.

2. A device according to claim 1 further comprising:
an insulator sheet (9;209) embedded in the insulator base (2;202) between the electrode layer (91;291) and the shield layer (92;292).

3. A device according to claim 2, wherein said insulator sheet is made of vitreous material, epoxy resin or polyimide resin.

4. A device according to claim 1, 2 or 3 wherein the electrode layer is provided with two side portions extending in the direction of said grooves, of greater length than its central portion, to form substantially an H-shaped configuration in plan view, whereby the static capacitance has an even distribution.

5. A device according to any one of the preceding claims, wherein said insulator base (202) comprises an upper half (222) and a lower half (223) which are integrally connected by means of a pivot portion (221), both said upper half (222) and said lower half (223) providing said grooves (202A,202B) for holding said corresponding cables (205) when the two halves (222,223) are closed together;
and wherein said electrode layer (203;203a;291) is embedded in both halves (222,223) of the insulator base (202).

6. A device according to any one of the preceding claims wherein said electrode layer (3;203) is corrugated in section.

7. A device according to any one of the preceding claims wherein said electrode layer comprises an electrode plate and said electrical shield layer comprises an electrical shield sheet.

8. A device according to any one of the preceding claims wherein the electrical shield layer is in the form of a mesh.

9. A device according to any one of the preceding claims, further comprising a ground wire (81;282) for grounding the shield layer (8;8a;92;222;281a;292) to the engine (E).

## Patentansprüche

1. Zündkerzen-Spannungsfühlervorrichtung (1B;1C;1D;200B;200C;200D) zur Befestigung an einem Verbrennungsmotor (E) und zum Erfassen einer Spannung, die an Zündkerzen (P) angelegt ist, die in dem Verbrennungsmotor (E) über entsprechende Kabel (HC;205) angebracht sind, wobei die Vorrichtung folgendes umfaßt: eine Isolatorbasis (2;202) mit einer Vielzahl von Nuten (22;202A,202B), in denen die entsprechenden Kabel (HC;205) untergebracht werden sollen,
eine Elektrodenschicht (3;30;91 ;203;203a;291), die in der Isolatorbasis (2;202) entlang der Nuten (22;202A,202B) eingebettet ist, um eine statische Kapazität zwischen der Elektrodenschicht (3;30;91 ;203;203a;291) und den untergebrachten Kabeln (HC;205) zu bilden, wenn die Spannung quer zu den Zündkerzen (P) angelegt wird, und
einen Anschlußdraht (4;233), der vorgesehen ist, um die Elektrodenschicht (3;30; 91;203;203a;291) elektrisch an einem Mikrocomputer (7) anzuschließen, um so den Verbrennungszustand in dem Motor (E) auf der Basis der statischen Kapazität zwischen der Elektrodenschicht (3;30;91 ;203;203a;291) und den Kabeln (HC;205) zu analysieren, dadurch gekennzeichnet, daß sie außerdem
eine elektrische Abschirmschicht (8;8a;92;222;281a;292) umfaßt, die in der Isolatorbasis (2;202) in der Nähe der Elektrodenschicht (3;30;91 ;203;203a;291) eingebettet ist und sich auf einer Seite der Elektrodenschicht (3;30;91 ;203;203a;291) fern von den Nuten (22;202A,202B) befindet, um dadurch die Elektrodenschicht (3;30;91 ;203;203a;291) elektrisch abzuschirmen, wobei die elektrische Abschirmschicht (8; 8a;92;222;281a;292) zur Erdung an den Motor (E) angeschlossen werden kann.

2. Vorrichtung nach Anspruch 1, desweiteren mit:
einer Isolatorfolie (9;209), die in der Isolatorbasis (2;202) zwischen der Elektrodenschicht (91;291) und der Abschirmschicht (92;292) eingebettet ist.

3. Vorrichtung nach Anspruch 2, bei der die Isolatorfolie aus einem glasartigen Material, aus Epoxidharz oder aus Polyimidharz hergestellt ist.

4. Vorrichtung nach Anspruch 1, 2 oder 3, bei der die Elektrodenschicht mit zwei Seitenabschnitten versehen ist, die sich in der Richtung der Nuten erstrecken und die länger als ihr mittlerer Abschnitt sind, um in der Draufsicht eine im wesentlichen H-förmige Konfiguration zu bilden, wodurch die statische Kapazität eine gleichmäßige Verteilung erfährt.

5. Vorrichtung nach einem der vorhergehenden Ansprüche, bei der die Isolatorbasis (202) eine obere Hälfte (202) und eine untere Hälfte (223) umfaßt, die einstückig mit Hilfe eines Schwenkabschnitts (221) verbunden sind, wobei sowohl die obere Hälfte (222) als auch die untere Hälfte (223) die Nuten (202A,202B) zum Halten der entsprechenden Kabel (205) vorsehen, wenn die beiden Hälften (222,223) zusammengeschlossen sind,
und wobei die Elektrodenschicht (203;203a;291) in beiden Hälften (222,223) der Isolatorbasis (202) eingebettet ist.

6. Vorrichtung nach einem der vorhergehenden Ansprüche, bei der die Elektrodenschicht (3;203) im Schnitt gewellt ist.

7. Vorrichtung nach einem der vorhergehenden Ansprüche, bei der die Elektrodenschicht eine Elektrodenplatte umfaßt und die elektrische Abschirmschicht eine elektrische Abschirmfolie umfaßt.

8. Vorrichtung nach einem der vorhergehenden Ansprüche, bei der die elektrische Abschirmschicht die Form einer Masche aufweist.

9. Vorrichtung nach einem der vorhergehenden Ansprüche, außerdem mit einem Erddraht (81;282) zum Erden der Abschirmschicht (8;8a;92;222;281a;292) an dem Motor (E).

## Revendications

1. Dispositif capteur de tension de bougie d'allumage (1B ; 1C ; 1D ; 200B ; 200C ; 200D) destiné à être fixé sur un moteur à combustion interne (E) et à détecter une tension appliquée à des bougies d'allumage (P) installées dans le moteur à combustion interne, par l'intermédiaire de câbles correspondants (HC ; 205), le dispositif comportant :
une base isolante (2 ; 202) ayant plusieurs gorges (22 ; 202A, 202B) dans lesquelles les câbles correspondants (HC ; 205) doivent être placés,
une couche d'électrode (3 ; 30 ; 91 ; 203 ; 203a, 291) noyée dans la base isolante (2 ; 202) le long des gorges (22 ; 202A, 202B) pour former une capacité statique entre la couche d'électrode (3 ; 30 ; 91 ; 203 ; 203a ; 291) et des câbles placés (HC ; 205) lorsque la tension est envoyée aux bougies d'allumage (P), et
un fil conducteur (4 ; 233) agencé pour connecter électriquement la couche d'électrode (3 ; 30 ; 91 ; 203 ; 203a ; 291) à un microcalculateur (7) de manière à analyser les conditions de combustion dans le moteur à combustion interne (E) sur la base de la capacité statique entre la couche d'électrode (3 ; 30 ; 91 ; 203 ; 203a ; 291) et les câbles (HC ; 205), caractérisé en ce qu'il comporte de plus
une couche de blindage électrique (8 ; 8a ; 92 ; 222 ; 281a ; 292) noyée dans la base isolante (2 ; 202) à proximité de la couche d'électrode (3 ; 30 ; 91 ; 203 ; 203a ; 291), et située du côté de la couche d'électrode (3 ; 30 ; 91 ; 203 ; 203a ; 291) éloigné des gorges (22 ; 202A ; 202B) de manière à blinder électriquement la couche d'électrode (3 ; 30 ; 91 ; 203 ; 203a ; 291), la couche de blindage électrique (8 ; 8a ; 92 ; 222 ; 281a ; 232) pouvant être reliée au moteur (E) pour mise à la masse.

2. Dispositif selon la revendication 1, comportant de plus :
une feuille isolante (9 ; 209) noyée dans la base isolante (2 ; 202) entre la couche d'électrode (92 ; 291) et la couche de blindage (92 ; 292).

3. Dispositif selon la revendication 2, dans lequel ladite feuille isolante est constituée d'un matériau vitreux, d'une résine époxy ou d'une résine polyimide.

4. Dispositif selon la revendication 1, 2 ou 3, dans lequel la couche d'électrode est munie de deux parties latérales s'étendant dans la direction desdites gorges, ayant une longueur plus grande que sa partie centrale, pour former pratiquement une configuration en forme de H en vue de dessus, de sorte que la capacité statique a une répartition régulière.

5. Dispositif selon l'une quelconque des revendications précédentes, dans lequel ladite base isolante (202) comporte une moitié supérieure (222) et une moitié inférieure (223) qui sont reliées sous forme d'un tout par l'intermédiaire d'une partie de pivotement (221), les deux moitiés supérieure (222) et inférieure (223) fournissant lesdites gorges (202A, 202B) pour maintenir lesdits câbles correspondants (205) lorsque les deux moitiés (222, 223) sont fermées ensemble,
et dans lequel ladite couche d'électrode (203 ; 203a ; 291) est noyée dans les deux moitiés (222, 223) de la base isolante (202).

6. Dispositif selon l'une quelconque des revendications précédentes, dans lequel ladite couche d'électrode (3 ; 203) a une section transversale ondulée.

7. Dispositif selon l'une quelconque des revendications précédentes, dans lequel ladite couche d'électrode comporte une plaque d'électrode et ladite couche de blindage électrique comporte une feuille de blindage électrique.

8. Dispositif selon l'une quelconque des revendications précédentes, dans lequel la couche de blindage électrique a la forme d'un treillis.

9. Dispositif selon l'une quelconque des revendications précédentes, comportant de plus un fil de mise à la masse (81 ; 282) pour mettre à la masse la couche de blindage (8 ; 8a ; 92 ; 222 ; 281a ; 292) sur le moteur (E).
